# EUROPEAN PATENT APPLICATION

(11) **EP 4 746 261 A1**
(43) Date of publication of application: **20.05.2026**
(21) Application number: 25213596.7
(22) Date of filing: 05.11.2025
(51) Int. Cl.: H02K 5/20, H02K 11/33, H02K 9/19, H02K 7/14

(54) **PROPULSION UNIT**

(30) Priority: 05.11.2024 KR 20240155151
(71) Applicant: Hyundai Motor Company, Seoul 06797 (KR); Kia Corporation, Seoul 06797 (KR)
(72) Inventor: YOO, Hoan Ju, Hwaseong-si, Gyeonggi-do 18280 (KR); SHIN, Kwon Su, Hwaseong-si, Gyeonggi-do 18280 (KR); AN, Jeong Uk, Hwaseong-si, Gyeonggi-do 18280 (KR); LIM, Ki Tack, Hwaseong-si, Gyeonggi-do 18280 (KR); JANG, Yong Sok, Hwaseong-si, Gyeonggi-do 18280 (KR); YEO, Kyung Ku, Hwaseong-si, Gyeonggi-do 18280 (KR); KIM, Chee Mann, Hwaseong-si, Gyeonggi-do 18280 (KR); LEE, Kyung Jun, Hwaseong-si, Gyeonggi-do 18280 (KR); LEE, Kam Chun, Hwaseong-si, Gyeonggi-do 18280 (KR); JUN, Hyun Woo, Hwaseong-si, Gyeonggi-do 18280 (KR); LEE, Sung Ho, Hwaseong-si, Gyeonggi-do 18280 (KR); LEE, Jae Joon, Hwaseong-si, Gyeonggi-do 18280 (KR); LEE, Dong Su, Hwaseong-si, Gyeonggi-do 18280 (KR); HWANG, Yun Kyung, Hwaseong-si, Gyeonggi-do 18280 (KR); CHOI, Jong Hun, Hwaseong-si, Gyeonggi-do 18280 (KR); LEE, Hong Wook, Hwaseong-si, Gyeonggi-do 18280 (KR); JEUN, Jae Young, Hwaseong-si, Gyeonggi-do 18280 (KR)
(74) Representative: Isarpatent

(57) **Abstract**

A propulsion unit includes a stator, a rotor configured to rotate relative to the stator, an inverter electrically connected to the stator, a cooling housing that is disposed adjacent to the stator and the inverter and defines a cooling channel, where the cooling channel includes a plurality of channels configured to carry coolant independently and circulate the coolant around the stator and the inverter, and a cooling unit connected to the cooling channel, where the cooling unit includes at least one of a heat exchanger or a pump.

## Description

### TECHNICAL FIELD

The present disclosure relates to a propulsion unit including a stator, a rotor, and cooling channels.

### BACKGROUND

A mobility apparatus includes a transportation means capable of transporting people or cargo over a city by flying using a propulsion unit. For instance, the propulsion unit of the mobility apparatus may include a propeller and a drive unit that rotates the propeller, and the drive unit may include a motor and an inverter that supplies electric power to the motor.

In some cases, the motor may include a stator and a rotor. The rotor may be connected to a shaft connected to the propeller. The rotor may rotate based on electromagnetic interaction with the stator, and as the rotor rotates, the shaft and propeller may rotate. When the motor operates, heat may be generated. If the heat is not dissipated, fatal damage may occur to the drive unit. In addition, the inverter may also generate heat, and a cooling unit may be provided to reduce the heat generated in the inverter together with the motor. For example, the cooling unit may implement a heat exchange cycle for cooling.

In some cases, when there is a defect in any of components of the cooling unit, cooling may not be provided, which may result in safety issues of the mobility apparatus.

### SUMMARY

The present disclosure describes a propulsion unit capable of ensuring safety even when there is a defect in a cooling unit.

According to one aspect of the subject matter described in this application, a propulsion unit includes a stator, a rotor configured to rotate relative to the stator, an inverter electrically connected to the stator, a cooling housing that is disposed adjacent to the stator and the inverter and defines a cooling channel, the cooling channel including a plurality of channels configured to carry coolant independently and circulate the coolant around the stator and the inverter, and a cooling unit connected to the cooling channel, the cooling unit including at least one of a heat exchanger or a pump.

Implementations according to this aspect can include one or more of the following features. For example, the cooling channel can be disposed between the stator and the inverter. In some examples, the plurality of channels can include a first channel and a second channel that are disposed adjacent to each other, where the cooling unit includes (i) a first cooling unit connected to the first channel and (ii) a second cooling unit connected to the second channel, and the first cooling unit and the second cooling unit are configured to independently operate.

In some implementations, each of the plurality of channels can have an annular shape surrounding the stator. In some examples, outer surfaces of the plurality of channels can face the stator in a radial direction of the stator, and inner surfaces of the plurality of channels can face the inverter in the radial direction. In some examples, the first channel and the second channel can be separately arranged in an axial direction of the rotor and spaced apart from each other in the axial direction. In some examples, the first channel and the second channel are alternately arranged in an axial direction of the rotor.

In some implementations, a first portion and a second portion of the first channel define a separation space therebetween in the axial direction of the rotor, and the second channel is disposed in the separation space between the first and second portions of the first channel. In some implementations, a first portion and a second portion of the first channel define a first separation space therebetween in the axial direction of the rotor, where a first part and a second part of the second channel defines a second separation space therebetween in the axial direction of the rotor, the first portion of the first channel is disposed in the second separation space, and the first part of the second channel is disposed in the first separation space.

In some examples, the first channel can include a first connecting portion that connects the first portion of the first channel and the second portion of the first channel, and the second channel can include a second connecting portion that connects the first part of the second channel and the second part of the second channel. In some examples, the first connecting portion overlaps with the second channel in the axial direction of the rotor. In some examples, the second connecting portion overlaps with the first channel in the axial direction of the rotor.

In some examples, the first channel, the second channel, the first connecting portion, and the second connection portion are disposed along a common circumferential surface. In some examples, the first connecting portion and the second connection portion can extend parallel to the axial direction of the rotor. In some examples, each of the first channel and the second channel can include at least a portion that is radially recessed outward relative to the common circumferential surface. In some examples, the first connecting portion and the second connection portion are inclined with respect to the axial direction of the rotor.

In some implementations, the stator and the inverter can overlap with each other in a radial direction of the rotor. In some examples, the plurality of channels can be provided between the stator and the inverter in the radial direction. In some examples, the inverter can be positioned closer to an axial center of the rotor than the stator in the radial direction.

In some implementations, the plurality of channels can include a plurality of first annular channels spaced apart from one another in an axial direction of the rotor and a plurality of second annular channels spaced apart from one another in the axial direction, where the plurality of first annular channels and the plurality of second annular channels are spaced apart from one another in the axial direction and surround the stator. In some examples, two or more of the plurality of second annular channels are disposed between two of the plurality of first annular channels. In some examples, two or more of the plurality of first annular channels are disposed between two of the plurality of second annular channels.

### BRIEF DESCRIPTION OF THE DRAWINGS

The above and other objects, features and advantages of the present disclosure will become more apparent to those of ordinary skill in the art by describing example implementations thereof in detail with reference to the accompanying drawings.
FIG. 1 is a schematic diagram showing example modules of a movable mobility apparatus.
FIG. 2 is a view showing an example of a mobility apparatus.
FIG. 3 is a cross-sectional side view showing an example of a propulsion unit of a mobility apparatus.
FIG. 4 is a view showing an example of a cooling housing.
FIG. 5 is a view showing the cooling housing in which an inverter is disposed.
FIG. 6 is a block diagram showing an example of a dual cooling unit and a cooling channel.
FIG. 7 is a view showing a first example of the cooling channel.
FIG. 8 is a view showing a second example of the cooling channel.
FIG. 9 is a view showing a third example of the cooling channel.
FIG. 10 is a view showing a fourth example of the cooling channel.
FIG. 11 is a graph showing an example of the temperature around a stator core when a cooling unit normally operates without failure.
FIG. 12 is a graph showing an example of the temperature around a stator when cooling is performed through the cooling channel according to the first example in a case where some of a first cooling unit and a second cooling unit fail and cooling is performed through one cooling unit.
FIG. 13 is a graph showing an example of the temperature around a stator when cooling is performed through the cooling channel according to the second example in a case where some of a first cooling unit and a second cooling unit fail and cooling is performed through one cooling unit.
FIG. 14 is a graph showing an example of the temperature around a stator when cooling is performed through the cooling channel according to the third example in a case where some of a first cooling unit and a second cooling unit fail and cooling is performed through one cooling unit.
FIG. 15 is a graph showing the output of a propulsion unit when cooling is performed through the cooling channel according to the first example in a case where some of the first cooling unit and the second cooling unit fail and cooling is performed through one cooling unit.
FIG. 16 is a graph showing the output of a propulsion unit when cooling is performed through the cooling channel according to the second example in a case where some of the first and second cooling units fail and cooling is performed through one cooling unit.
FIG. 17 is a graph showing the output of a propulsion unit when cooling is performed through the cooling channel according to the third example in a case where some of the first and second cooling units fail and cooling is performed through one cooling unit.

### DETAILED DESCRIPTION

The present disclosure can be variously modified and implemented, and example implementations thereof will be illustrated in the drawings and described. However, this is not intended to limit the present disclosure to the specific implementations, and it should be understood to include all modifications, equivalents, and substitutes included in the spirit and scope of the present disclosure.

Hereinafter, implementations will be described in detail with reference to the accompanying drawings, but identical or corresponding components are denoted by the same reference numerals regardless of figure numbers, and redundant descriptions thereof will be omitted.

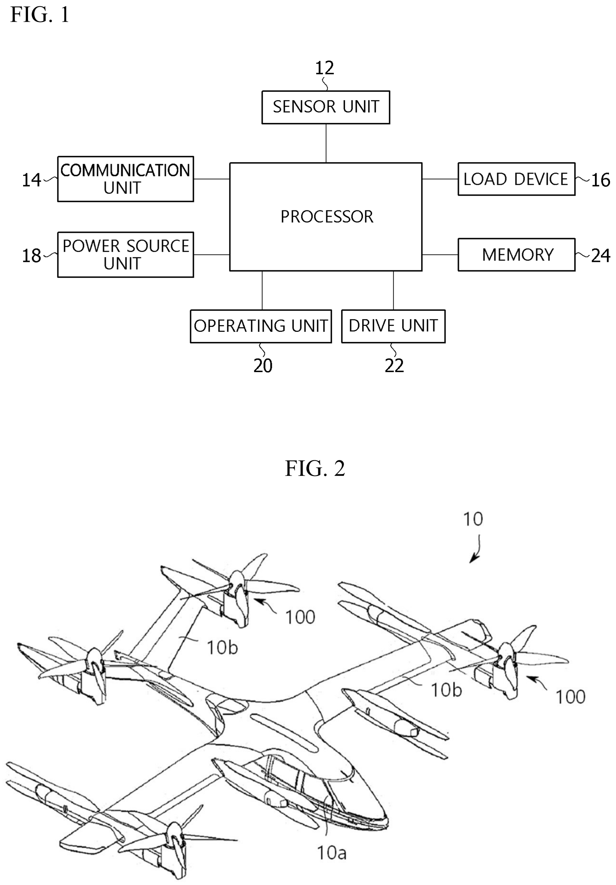

Hereinafter, FIG. 1 is a schematic diagram showing example modules of movable mobility apparatuses.

For example, a mobility apparatus 10 can be a mobile body having mobility in the present disclosure. Mobility is the ability to carry people, objects for a specific purpose, and/or luggage while moving from one point to a specific point. That is, the mobility apparatus 10 moves for transportation and other purposes, and the other purposes can include detecting or monitoring an environment around the mobility apparatus 10 while carrying an observation device, for example. For a more specific example, the mobility apparatus 10 can be equipped with a camera to photograph or analyze a surrounding environment and transmit the photographed or analyzed image to a predetermined device. The mobility apparatus 10 can be used for various purposes without being limited to the above examples.

The mobility apparatus 10 can move through spaces related to the ground, underground, air, space, sea, and/or underwater, depending on the space in which it moves. The ground or underground mobility apparatus 10 can be provided in the form of, for example, a vehicle, a robot, or the like, and the air or space mobility apparatus 10 can be provided as an aerial mobility apparatus, for example, in the form of a typical fixed-wing or rotary-wing aircraft, an advanced air mobility (AAM) that has been actively developed recently, an unmanned aircraft or drone, a rocket, a transportation means mounted on an artificial satellite, or the like. The sea or underwater mobility apparatus 10 can be, for example, a ship, a submarine, or the like. The mobility apparatus 10 can be a mobile body that can move through all of the spaces described above without being limited to a specific space, that is, a mobile body that can move between a plurality of spaces, for example, an amphibious vehicle, a flying vehicle, or the like.

In addition, the mobility apparatus 10 can be moved through manual operation, autonomy control, or a combination thereof. The manual operation can be implemented by a driver or an operator through an interface such as a control device provided on the mobility apparatus 10, or by remote control by a control center or an external control center. The autonomy control, that is, autonomous movement, can be performed by independent processing of the mobility apparatus 10, or by a combination of remote control through a control center and collaborative processing of the mobility apparatus 10 with the control center, or the like.

In some examples, the mobility apparatus 10 operated in various forms can be differently designed depending on the purpose, movement space, driving method, control method, or the like, but can have a common function module as exemplified in FIG. 1 from a comprehensive perspective such as mobility. FIG. 1 mainly describes common functions in various types of mobility apparatuses 10. Accordingly, although a function module utilized in each type may be omitted, the implementation of the present disclosure does not exclude the module that is omitted from the mobility apparatus 10 in FIG. 1 and does not exclude the module from the scope of rights according to the present implementation.

The mobility apparatus 10 can include a sensor unit 12, a communication unit 14, and a load device 16.

The sensor unit 12 can be equipped with various types of detectors that detect various states and situations occurring in external and internal environments of the mobility apparatus 10 and identify the position information about the mobility apparatus 10. That is, the sensor unit 12 can include different types of sensors and acquire sensing data detected from each sensor. The sensor unit 12 can obtain sensor data used for movement control, state data for detecting a state of modules constituting the mobility apparatus 10, situation data for detecting the situation of occupants and/or loads, and the like, and provide them to a processor 26 that triggers a predetermined function and operation. In the present disclosure, the movement control can be at least one of motion controls related to linear movement, turning, and acceleration/deceleration of the mobility apparatus 10, and attitude control, braking, hovering, and the like of the mobility apparatus 10. In the present disclosure, hovering can be a control in which thrust is generated in a downward or vertical direction with respect to the mobility apparatus 10, thereby causing a predetermined operation or movement of the mobility apparatus 10. The predetermined operation or movement can be, for example, takeoff, landing, or substantially stationary flight within a limited range. The data of the sensor unit 12 described above is merely example, and can additionally include sensor data for detecting various situations not listed herein.

The communication unit 14 can support mutual communication with other devices to exchange data with other external devices. Examples of other devices can include a server that controls the mobility apparatus 10 or mutually exchanges data related to movement control of the mobility apparatus 10, ancillary devices for supporting movement, other mobility apparatuses, or the like. The server can be referred to by various terms, such as a control device, a management device, a controlling device, or the like. The communication unit 14 can transmit data generated or stored during movement to another device and receive data and software modules transmitted from another device. A protocol applied to the communication unit 14 can be determined according to the type of mobility apparatus 10, and can allow communication with other vehicles or other devices for example, based on cellular communication, wireless access in vehicular environment (WAVE) communication, dedicated short range communication (DSRC), or short-range communication, or other communication methods. The communication protocol and methods listed above are example and not limiting.

The load device 16 can be an auxiliary device that is mounted on the mobility apparatus 10 and consumes electric power supplied from a power source unit 18 or converted from the output of the power source unit 18 by a command for use by a user or management of loads. The load device 16 can be a type of non-mobile electric device other than a mobile power system used in the drive unit 22 or the like in the present disclosure. The load device 16 can be, for example, a display system, an air conditioning system, a lighting system, a seat system, and various devices installed in the mobility apparatus 10.

In some implementations, the mobility apparatus 10 can include an interface for receiving requests for movement control and the operation of the load device 16. The interface can be implemented as a hardware device, a software interface, or the like. The hardware interface can be a hardware manipulator for the movement motion that the user requests from the mobility apparatus 10, and can be, for example, an aircraft joystick, a ground steering wheel, a ground pedal, a button, a marine steering handler, or the like, but is not limited thereto. The software interface can be a touch-enabled display, for example, but is not limited thereto.

In addition, the mobility apparatus 10 can include a power source unit 18, an operating unit 20, and a drive unit 22.

The power source unit 18 can generate and supply power and electric power used in the mobile power system such as the drive unit 22 and the load device 16. The mobility apparatus 10 can generate energy by at least one of various energy sources. When the mobility apparatus 10 is driven by electric energy, the power source unit 18 can be, for example, an electric battery, or a combination of an electric battery and a charging module that charges the battery. When the power source unit 18 is an electric battery only, the electric battery can be charged from a charging station or other mobility apparatus to supply electric power. In the case of the combination of the electric battery and the charging module, the power source unit 18 can employ at least one of a fuel cell and a fossil energy-based engine as the charging module. The fuel cell can use substances, such as hydrogen gas, to generate electric power. In the case of the engine, the power source unit 18 can have a generator coupled to the engine, and the generator can convert mechanical energy generated by the engine into electrical energy and charge the electric battery with the converted electrical energy.

As another example, when the mobility apparatus 10 is driven by fossil energy or nuclear fuel, the power source unit 18 can be an internal combustion engine, a turbine engine, or a nuclear fuel-based engine. As still another example, the mobility apparatus 10 can have the power source unit 18 configured in a hybrid form by a fossil energy-based engine and an electric battery. The hybrid power source unit 18 can charge the electric battery using the engine output generated during movement, and can generate a driving force for the drive unit 22 by selecting any one of the power of the engine or the electric power of the electric battery depending on the state of the mobility apparatus 10, the properties of a movement route, a movement situation, and the like. As another example, the hybrid power source unit 18 can include an electric battery that can be charged by an external source and an engine. The processor 26 switches between the power of the engine and the electric power of the electric battery depending on various situations and states to apply the energy to the drive unit 22, and thus, a moving driving force can be generated.

The operating unit 20 and the drive unit 22 can form an actuating unit that transmits power generated from the power source unit 18 to implement a predetermined movement motion to the outside. In the present disclosure, the actuating unit is referred to as an actuator, and the terms can be interchangeably used and described.

The operating unit 20 can be equipped with at least one module that implements a movement motion. When the mobility apparatus 10 is a mobility apparatus, the operating unit 20 can be equipped with mechanical and software components that perform at least one operation among, for example, control of flight attitudes such as roll, yaw, pitch, and the like, of the mobility apparatus 10, hovering control related to takeoff and landing, and flap control for altitude change and turning operation. When the mobility apparatus 10 is a ground mobility, the operating unit 20 can have mechanical and software components that realize at least one driving operation, for example, longitudinal control such as acceleration and deceleration, and lateral control such as steering. The operating unit 20 of the ground mobility can further include a module for transmitting power from the power source unit 18 to the drive unit 22 and a module for converting the power to the drive unit 22 into power with a predetermined size and shape.

The drive unit 22 can be a module for externally implementing linear movement, turning, acceleration/deceleration of the mobility apparatus 10, and attitude control, braking, hovering, or the like, of the mobility apparatus 10, and can be implemented in various forms depending on the type of the mobility apparatus 10. When the mobility apparatus 10 is a typical mobility apparatus, a moving drive unit of a fixed-wing mobility apparatus can be a turbine engine, a flap, or the like, installed on a main wing, a tail wing, or the like, to realize motions related to the thrust and lift of the mobility apparatus. As another example, the fixed-wing mobility apparatus can additionally include a propulsion unit, such as a propeller, on a designated portion of the main wing. The drive unit 22 of a typical rotary wing mobility apparatus can be a rotor type propulsion unit, a flap, or the like, installed on an upper portion of a fuselage and the tail wing. The typical mobility apparatus can be equipped with wheels, such as landing gear for takeoff and landing, depending on its specifications, and wheels can be accommodated within the fuselage during flight. The AAM type drive unit 22 can be equipped with a rotor type propulsion unit and a flap, similar to a rotary wing mobility apparatus. The propulsion unit applied to the AAM type drive unit can be fixed to the main wing to be at least non-tiltable, or can be installed in the main wing to be at least tiltable. As another example, a plurality of propulsion units that are applied to the AAM type drive unit can also be installed inside the main wing. In addition, the AAM type drive unit 22 can be configured to rotate the wing to which the propulsion unit is coupled within a predetermined angular range. The AAM type drive unit 22 can be equipped with wheels, such as landing gear, which are accommodated within the fuselage during flight and taken out during takeoff and landing, depending on the specifications. When the AAM type mobility apparatus is driven by electric energy, the drive unit 22 can mainly include a motor that rotates the propeller by electric power and an inverter. When the AAM type mobility apparatus is driven by non-electric energy, such as fossil energy, the drive unit 22 can mainly include modules for transmitting rotational power generated by an internal combustion engine to the propeller.

When the mobility apparatus 10 is a ground mobility, the drive unit 22 can include a plurality of wheels, a driving force transmission module for generating a driving force and applying the driving force to the wheels or transmitting the driving force, a braking module for slowing down the driving of the wheels, a steering module for realizing lateral control of the wheels, and the like. Wheels, the driving force transmission module, the braking module, and the like, can constitute a driving assembly, and a plurality of driving assemblies can be provided depending on the number of wheels.

When the mobility apparatus 10 is driven based on electrical energy, the driving force transmission module can be configured as a motor module that generates a driving force based on electric power output from the electric battery.

In addition, the mobility apparatus 10 can include a memory 24 and a processor 26.

The memory 24 can store applications and various data for controlling the mobility apparatus 10 and load applications or read and record data by a request of the processor 26. The applications and data can vary depending on the type and detailed specifications of the mobility apparatus 10, and include sensor data related to movement control, state data of the mobility apparatus related to movement control, data received from other devices, and data related to energy control between the power source unit 18 and the drive unit 22. In addition, the applications and data can include data related to the control of modules in charge of functions other than the controls described above, software related to the operation of the computing system of the mobility apparatus, information and applications for autonomous movement, route information, various information and control programs for boarding convenience, or the like.

Regarding the present disclosure, the processor 26 can process movement control, route control, energy control, control of the load device 16, autonomous movement control, convenience function control, or the like, using the applications, instructions, and data stored in the memory 24. The processor 26 can also have different control processes depending on the type and detailed specifications of the mobility apparatus 10. The processor 26 may, for example, be implemented as a single processing module. As another example, the processing according to the above-described matters can be distributed in a plurality of processing modules, and the plurality of processing modules can be collectively referred to as the processor 26 in the present disclosure.

In the present disclosure, among various types of mobility apparatuses, the AAM type mobility apparatus is mainly described. Although the AAM type mobility apparatus is described, functions, modules, and devices of the mobility apparatus described in the present disclosure are also applicable to other types of mobility apparatuses as long as the functions, modules, and devices are technically combinable. In a broad sense, when the functions, modules, and devices of the mobility apparatus described in the present disclosure are technically combinable, the functions, modules, and devices can also be applicable to mobility apparatuses on land, underground, space, sea, and underwater.

FIG. 2 is a view showing a mobility apparatus according to one example.

In some implementations, the mobility apparatus 10 can include a streamlined fuselage 10a and wings 10b such as a main wing and a tail wing connected to the fuselage 10a. The fuselage 10a can have, for example, a cabin for the pilot and passengers and a space for loading baggage.

A plurality of propulsion units can be disposed on the wings 10b, and each of the propulsion units 100 can include a propeller and a motor that rotates the propeller, an inverter that adjusts the electric power of the power source unit 18 or converts an electric power form based on a flight situation, motor specifications, or the like, and a cooling unit that cools heat generated in the motor and the inverter. The propeller can be arranged parallel to the fuselage 10a.

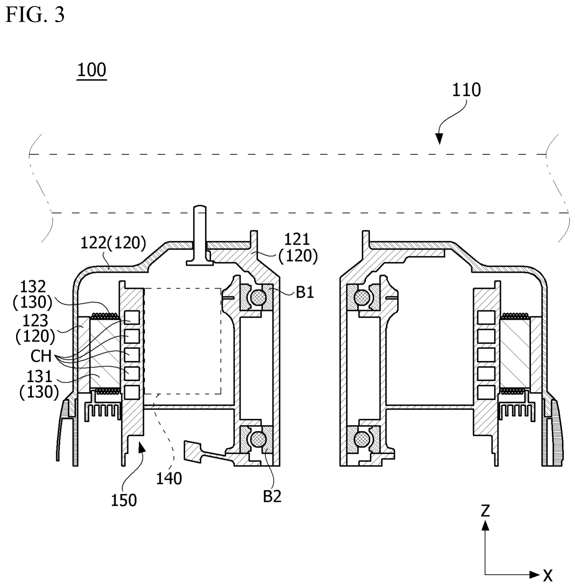

FIG. 3 is a cross-sectional view showing an example of a propulsion unit 100 of a mobility apparatus.

Referring to FIG. 3, in some implementations, the propulsion unit 100 of the mobility apparatus can include a propeller 110, a rotor 120, a stator 130, an inverter 140, and a cooling housing 150. Hereinafter, an axial direction of the propulsion unit 100 represents a longitudinal direction of a shaft 121, and a radial direction represents a direction perpendicular to the axial direction. Hereinafter, in the drawings, a z-axis represents the axial direction, and an x-axis represents the radial direction.

The propeller 110 is coupled to the shaft 121 of the rotor 120 to generate lift by rotating together when the rotor 120 rotates.

The rotor 120 can include the shaft 121, a yoke 122, and a magnet 123. The yoke 122 can be a cylindrical member with one end open in the axial direction. The shaft 121 can be coupled to an upper portion of the yoke 122. Further, the magnet 123 can be fixed to an inner surface of a side portion of the yoke 122. The magnet 123 can be formed by combining a plurality of split magnets, or can be a single ring-shaped magnet.

The stator 130 can be fixed to the cooling housing 150. The stator 130 is positioned opposite the rotor 120. The stator 130 can be positioned on an inner side of the stator 130 in the radial direction. That is, the rotor 120 can be disposed on an outer side of the stator 130. Here, the term "inner" refers to a direction toward the shaft 121 based on the radial direction, and the term "outer" refers to a direction away from the shaft 121 based on the radial direction.

The stator 130 can include a coil 132 wound around a stator core 131.

The inverter 140 can be fixed to the cooling housing 150. Further, the inverter 140 can be positioned on an inner side of the stator 130. That is, the inverter 140 can be disposed to overlap the stator 130 in the radial direction. The inverter 140 can be disposed closer to an axial center of the propeller 110 in the radial direction than the stator 130. Since the inverter 140 is disposed between the stator 130 and the shaft 121 in the radial direction in this way, there is an advantage in that the size of the propulsion unit 100 can be significantly reduced in the axial direction.

The cooling housing 150 is disposed on an outer side of the shaft 121. Further, the cooling housing 150 is positioned on the inner side of the stator 130. The cooling housing 150 can include a plurality of cooling channels CH. The cooling channels CH can be positioned between the stator 130 and the inverter 140 in the radial direction. Unlike the shaft 121, the cooling housing 150 does not rotate but is fixed. Bearings B1 and B2 can be fixed to the cooling housing 150. The bearings B1 and B2 rotatably support the shaft 121. The bearings B1 and B2 can include an upper bearing B1 and a lower bearing B2. The upper bearing B1 can be disposed at an upper portion of the cooling housing 150, and the lower bearing B2 can be disposed at a lower portion of the cooling housing 150.

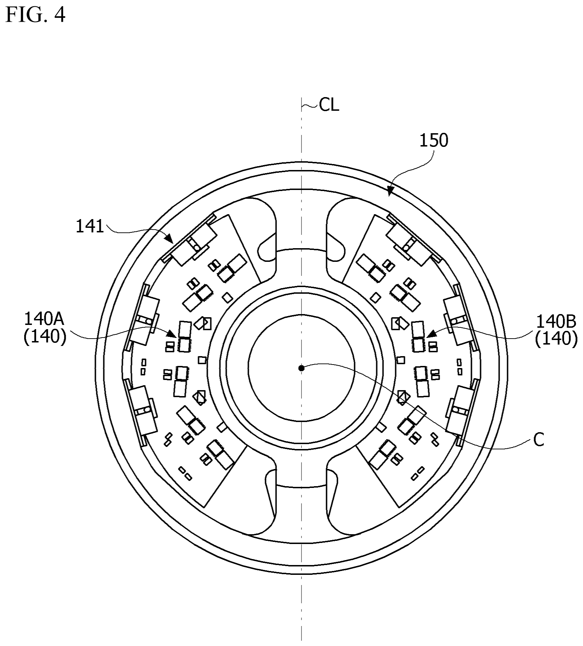

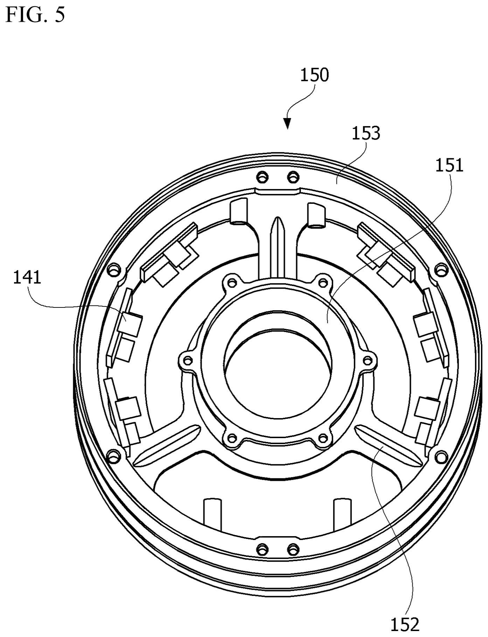

FIG. 4 is a view showing the cooling housing 150, and FIG. 5 is a view showing the cooling housing 150 in which the inverter 140 is disposed.

Referring to FIGS. 4 and 5, the cooling housing 150 can include a cylindrical hub 151, a female portion 152 extending from the hub 151 in the radial direction, and a rim portion 153 connected to the female portion 152. A cooling channel CH can be formed inside the rim portion 153. The cooling channel CH is an empty space of the cooling housing 150 formed along the rim portion 153, and through the space, coolant flows. A plurality of cooling channels CH can be provided.

The stator 130 is fixed by being in contact with the outer surface of the rim portion 153. The inverter 140 can be positioned on the inner side of the rim portion 153. Among the elements of the inverter 140, an element 141 that generates a lot of heat can be fixed to the rim portion 153 by being in direct contact with the inner surface of the rim portion 153.

As shown in FIG. 5, the inverter 140 can be positioned between the rim portion 153 and the hub 151 in the radial direction and fixed to the cooling housing 150. Since the inverter 140 is disposed directly adjacent to the rim portion 153 having the cooling channel CH, the heat generated in the inverter 140 can be directly and effectively exchanged with the coolant flowing in the cooling channel CH. The element 141 in direct contact with the cooling housing 150 can be a silicon carbide power module.

The inverter 140 can include a control board, a gate board electrically connected to the control board, and a capacitor board electrically connected to the control board and the gate board. Further, the inverter 140 can include a first inverter 140A and a second inverter 140B. The first inverter 140A and the second inverter 140B are separately provided in terms of circuit to independently operate. When any one of the first inverter 140A and the second inverter 140B fails, electric power can be supplied to the propulsion unit 100 through the inverter that is not failed.

When viewed in the axial direction, the first inverter 140A can be disposed on one side of a reference line CL passing through the center of the axis, and the second inverter 140B can be disposed on the other side of the reference line CL. The first inverter 140A and the second inverter 140B can be disposed symmetrically with respect to the reference line CL.

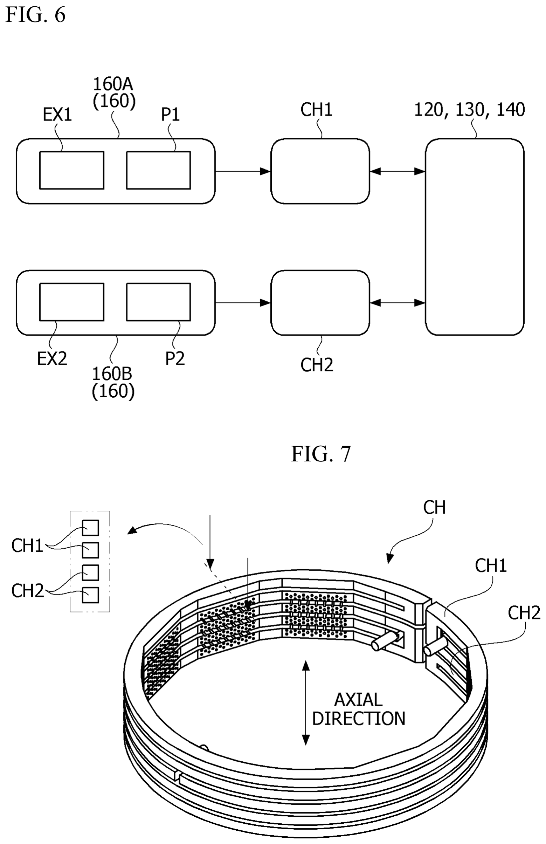

FIG. 6 is a block diagram illustrating an example of a dual cooling unit and a cooling channel CH.

Referring to FIG. 6, in some implementations, a cooling unit 160 and the cooling channel CH are provided to remove heat generated in the rotor 120, the stator 130, and the inverter 140, and the mobility apparatus has dual cooling loops to prepare for a failure of the cooling unit 160. The dual cooling loops can each operate independently.

The cooling channel CH can include a first channel CH1 and a second channel CH2. Coolant independently circulates through the first channel CH1 and the second channel CH2. The first channel CH1 is connected to the first cooling unit 160A. The first cooling unit 160A can include a first pump P1, a first heat exchanger EX1, and the like, to implement a cooling loop that exchanges heat generated in the rotor 120, the stator 130, and the inverter 140 through the first channel CH1. The second channel CH2 is connected to the second cooling unit 160B. The second cooling unit 160B can include a second pump P2, a second heat exchanger EX2, and the like, to implement a cooling loop that exchanges heat generated in the rotor 120, the stator 130, and the inverter 140 through the second channel CH2, but is independent of the cooling loop through the first channel CH1.

As one example, when any component of the first cooling unit 160A fails, cooling can be performed corresponding to the heat generated in the rotor 120, the stator 130, and the inverter 140 through the second cooling unit 160B and the second channel CH2.

FIG. 7 is a view showing a first example of the cooling channel CH.

FIG. 7 is a view illustrating the cooling channel CH formed inside the cooling housing 150 so that the cooling channel CH can be visually confirmed.

The cooling channel CH according to the first example can include a first channel CH1 and a second channel CH2 which are adjacent to each other in the axial direction. The first channel CH1 and the second channel CH2 can be disposed to be separated in the axial direction. When viewed in the axial direction, the first channel CH1 and the second channel CH2 can be disposed to overlap each other.

The first channels CH1 can be formed in an annular shape, can be disposed in a plurality of rows based on the axial direction, and can include a plurality of banding portions. Both ends of the first channel CH1 can include an inlet and an outlet connected to the first cooling unit 160A, respectively.

Hereinafter, a layer of a cooling channel CH positioned at the top in the drawing in the axial direction is referred to as a first row, and the cooling channels CH are disposed in the order of the first row, a second row, a third row, a fourth row, and a fifth row from top to bottom.

The first channel CH1 and the second channel CH2 can each be disposed in a plurality of rows. For example, the cooling channels CH can be arranged in five rows in the axial direction, and according to circumferential positions of the cooling channels CH, at a certain point, the first channels CH1 can be disposed in the first and second rows based on the axial direction, and the second channels CH2 can be disposed in the third, fourth, and fifth rows. Further, according to the circumferential positions of the cooling channel CH, at a different point, the first channels CH1 can be disposed in the first, second, and third rows based on the axial direction, and the second channels CH2 can be disposed in the fourth and fifth rows. Since the first channel CH1 and the second channel CH2 are positioned adjacent to each other in the axial direction, even when any one of the first cooling unit 160A connected to the first channel CH1 and the second cooling unit 160B connected to the second channel CH2 fails, cooling is possible through the cooling channel CH that does not fail.

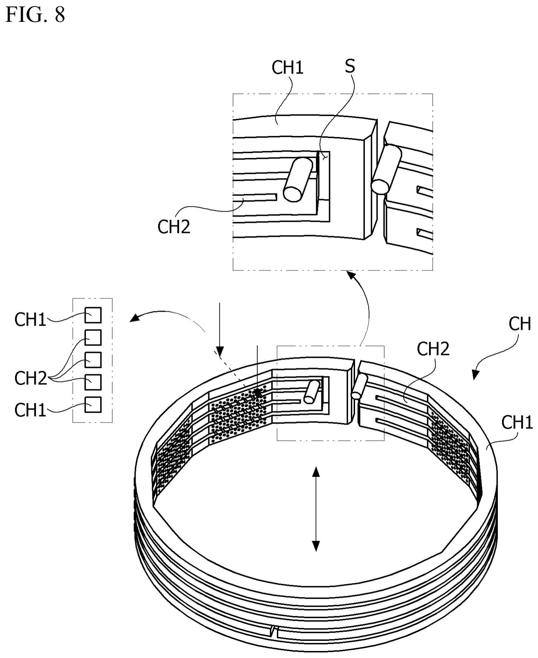

FIG. 8 is a view showing a second example of the cooling channel CH.

Referring to FIG. 8, the cooling channel CH according to the second example can have a first channel CH1 and a second channel CH2 alternately disposed in the axial direction. A portion of the first channel CH1 and another portion thereof can form a separation space in the axial direction, and the second channel CH2 can be disposed in the separation space. For example, one row and the other row of the first channel CH1 can form a separation space S in the axial direction, and the second channel CH2 can be positioned in the separation space S. For example, when viewed in the axial direction, the cooling channels CH can be disposed in the order of the first channel CH1, the second channel CH2, and the first channel CH1. When viewed in the axial direction, the first channel CH1 and the second channel CH2 can be disposed to overlap each other. For example, the cooling channels CH can be arranged in five rows in the axial direction, and according to circumferential positions of the cooling channels CH, at some point, the first channels CH1 can be disposed in the first and fifth rows based on the axial direction, and the second channels CH2 can be disposed in the second, third, and fourth rows based on the axial direction. Further, according to the circumferential positions of the cooling channel CH, at different points, the first channels CH1 can be disposed in the first, fourth, and fifth rows based on the axial direction, and the second channels CH2 can be disposed in the second and third rows.

Since the first channels CH1 and the second channels CH2 are alternately disposed in the axial direction in this way, even when only one cooling channel CH is operated due to a failure, cooling can be achieved more evenly in the axial direction.

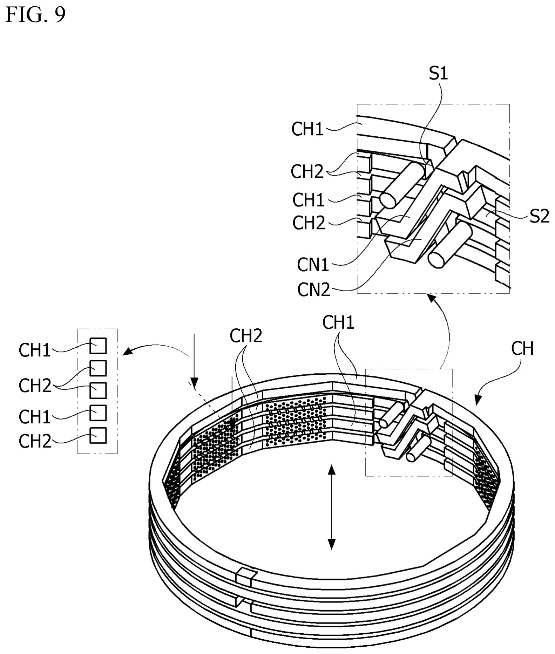

FIG. 9 is a view showing a third example of the cooling channel.

Referring to FIG. 9, the cooling channel CH according to the third example can have a first channel CH1 and a second channel CH2 alternately disposed in the axial direction. Specifically, a portion of the first channel CH1 and another portion thereof can form a first separation space S1 in the axial direction, and a portion of the second channel CH2 and another portion thereof can form a second separation space S2 in the axial direction. The second channel CH2 can be positioned in the first separation space S1, and the first channel CH1 can be positioned in the second separation space S2. For example, when viewed in the axial direction, the cooling channels CH can be disposed in the order of the first channel CH1, the second channel CH2, the first channel CH1, and the second channel CH2. When viewed in the axial direction, the first channel CH1 and the second channel CH2 can be disposed to overlap each other.

The first channel CH1 can include a first connecting portion CN1 connecting the portion of the first channel CH1 and another portion of the first channel CH1 that are separated by the first separation space. For example, the first connecting portion CN1 can be connected to the first channel CH1 of the fourth row across the second channel CH2 from the first channel CH1 of the first row.

The second channel CH2 can include a second connecting portion CN2 connecting the portion of the second channel CH2 and another portion of the second channel CH2 that are separated by the second separation space S2. For example, the second connecting portion CN2 can be connected to the second channel CH2 of the fifth row across the first channel CH1 from the second channel CH2 of the second row.

The first connection portion CN1 can be disposed to overlap the second channel CH2 in the axial direction. The second connection portion CN2 can be disposed to overlap the first channel CH1 in the axial direction.

For example, the cooling channels CH can be arranged in five rows in the axial direction, and according to circumferential positions of the cooling channels CH, at some point, the first channels CH1 can be disposed in the first and fourth rows based on the axial direction, and the second channels CH2 can be disposed in the second, third, and fifth rows. Further, according to the circumferential positions of the cooling channel CH, at different points, the first channels CH1 can be disposed in the first, third, and fourth rows based on the axial direction, and the second channels CH2 can be disposed in the second and fifth rows.

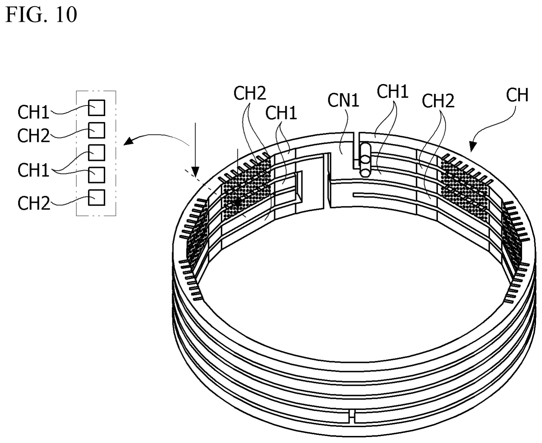

FIG. 10 is a view showing a fourth example of the cooling channel.

Referring to FIG. 10, first channels CH1 and second channels CH2 can be disposed in a plurality of rows. Each of the first channel CH1 and the second channel CH2 can include a plurality of banding regions. The first channel CH1 and the second channel CH2 can be alternately disposed in the axial direction. The first channel CH1 can include a first connecting portion CN1 connecting the portion of the first channel CH1 and another portion of the first channel CH1 that are separated by the first separation space. For example, the first connecting portion CN1 can connect the second channel CH2 of the third row across the second channel CH2 from the first channel CH1 of the first row. The second channel CH2 can include a second connecting portion CN2 connecting the portion of the second channel CH2 and another portion of the second channel CH2 that are separated by the second separation space. For example, the second connecting portion CN2 can be connected to the second channel CH2 of the fifth row across the first channel CH1 from the second channel CH2 of the second row. For example, when viewed in the axial direction, the cooling channels CH can be disposed in the order of the first channel CH1, the second channel CH2, the first channel CH1, and the second channel CH2. When viewed in the axial direction, the first channel CH1 and the second channel CH2 can be disposed to overlap each other.

In some examples, the first connecting portion CN1 and the second connecting portion CN2 can be disposed to overlap in the axial direction. Further, the first connecting portion CN1 and the second connecting portion CN2 can be disposed to overlap the first channel CH1 and the second channel CH2 in the axial direction.

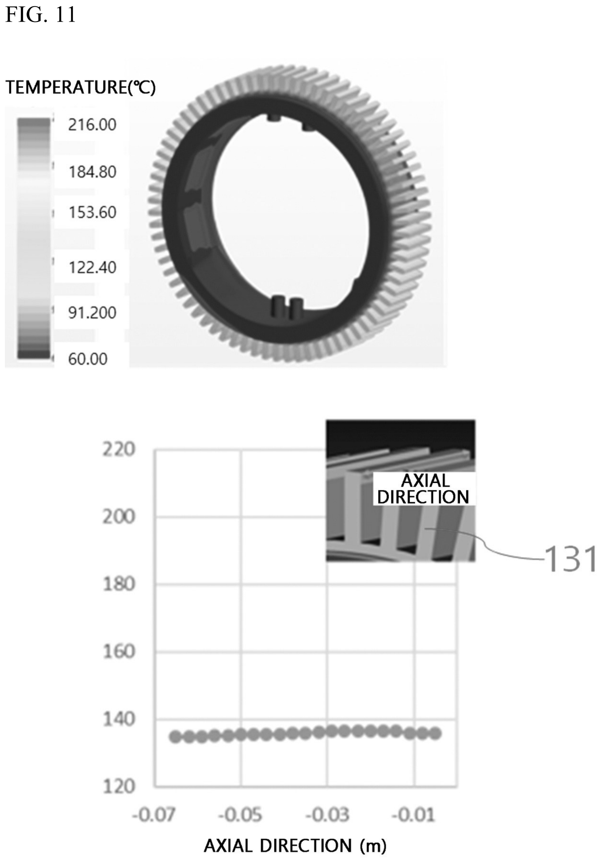

FIG. 11 is a graph showing an example of the temperature around the stator core 131 when the cooling unit 160 normally operates without failure.

Referring to FIG. 11, it can be confirmed that the cooling unit 160 normally operates without failure, and the temperature around the stator core 131 is maintained below 140 °C. In particular, since cooling is normally performed in the first channel CH1 and the second channel CH2, it can be confirmed that the temperature around the stator core 131 in the axial direction is cooled and maintained to be constant.

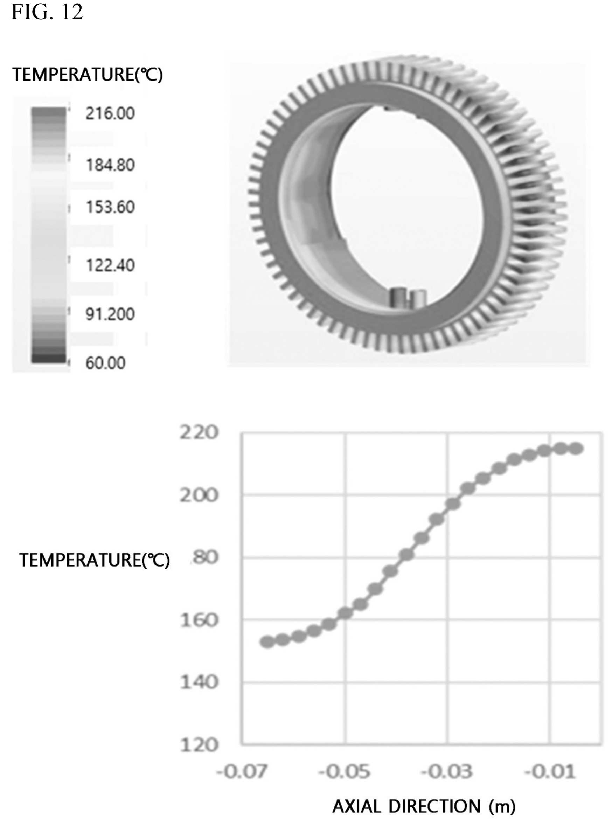

FIG. 12 is a graph showing an example of the temperature around the stator 130 when cooling is performed through the cooling channel CH according to the first example in a case where some of the first cooling unit 160A and the second cooling unit 160B fail and cooling is performed through one cooling unit 160.

Referring to FIG. 12, it can be confirmed that when some of the first cooling unit 160A and the second cooling unit 160B fail and cooling is performed only by one cooling unit 160, cooling is performed through the cooling channel CH connected to the cooling unit 160 that is normally operating, and the temperature around the stator core 131 drops to some extent.

In some examples, where the first channel CH1 and the second channel CH2 are completely separated in the axial direction, the cooling effect may be reduced in a region corresponding to the cooling channel CH connected to the failed cooling unit 160. Therefore, the temperature around the stator core 131 may be uneven along the axial direction. That is, in the axial direction, one side is well cooled and has a low temperature, while the other side has a relatively high temperature since the cooling effect is lowered.

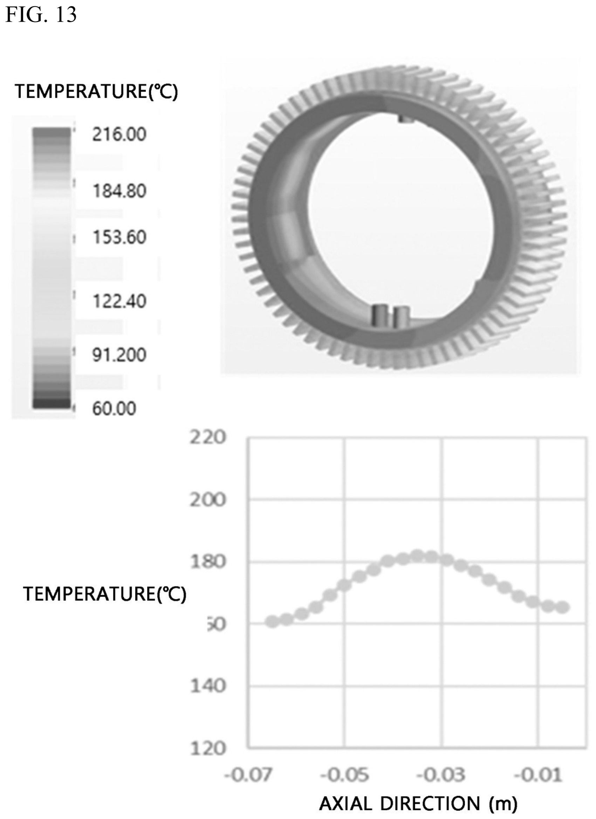

FIG. 13 is a graph showing an example of the temperature around the stator 130 when cooling is performed through the cooling channel CH according to the second example in a case where some of the first cooling unit 160A and the second cooling unit 160B fail and cooling is performed through one cooling unit 160.

Referring to FIG. 13, the cooling channel CH according to the second example has the second channel CH2 positioned between the first channels CH1 in the axial direction. Therefore, even when the second cooling unit 160B connected to the second channel CH2 fails, the second channel CH2 can be cooled by the adjacent first channels CH1. Since the cooling channels are positioned in the order of the first channel CH 1, the second channel CH2, and the first channel CH1 in the axial direction, it can be confirmed that even when the second cooling unit 160B to which the second channel CH2 is connected fails, cooling is performed on both sides of the second channel CH2 in the axial direction, so that the temperature around the stator core 131 appears more uniform than in a case of the cooling channel CH according to the first example based on the axial direction.

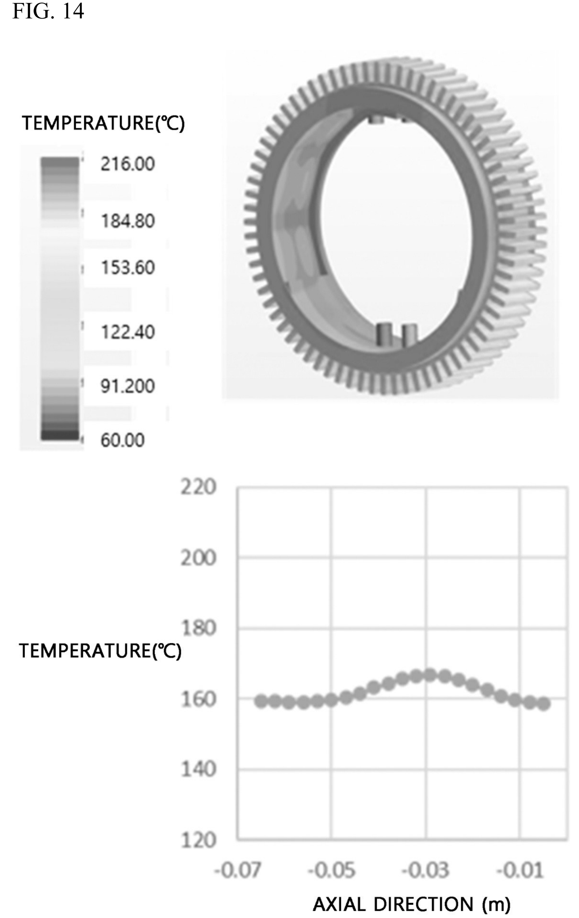

FIG. 14 is a graph showing an example of the temperature around the stator 130 when cooling is performed through the cooling channel CH according to the third example in a case where some of the first cooling unit 160A and the second cooling unit 160B fail and cooling is performed through one cooling unit 160.

Referring to FIG. 14, the cooling channel CH according to the third example has the first channel CH1 and the second channel CH2 alternately disposed in the axial direction. Since the cooling channels CH are positioned in the order of the first channel CH1, the second channel CH2, the first channel CH1, and the second channel CH2 in the axial direction, it can be confirmed that even when some of the cooling units 160A and 160B fail, the temperature around the stator core 131 is more uniform than in a case of the cooling channels CH according to the first and second examples based on the axial direction.

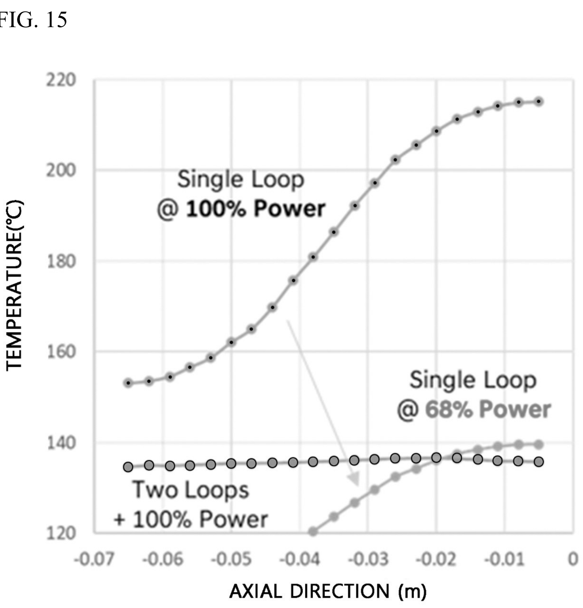

FIG. 15 is a graph showing an example of the output of the propulsion unit 100 when cooling is performed through the cooling channel CH according to the first example in a case where some of the first cooling unit 160A and the second cooling unit 160B fail and cooling is performed through one cooling unit 160.

Referring to FIG. 15, when the cooling units 160A and 160B are all normal (e.g., two loops for cooling circulate coolants), the output of the propulsion unit 100 can be maintained at 100%. In the case where some of the first cooling unit 160A and the second cooling unit 160B fail and cooling is performed through one cooling unit 160, since when cooling is performed through the cooling channel CH according to the first example, the temperature is high when the output is maintained at 100%, the output of the propulsion unit 100 can be adjusted to 68% to match the temperature when the cooling units 160A and 160B are all normal (e.g., two loops for cooling circulate coolants).

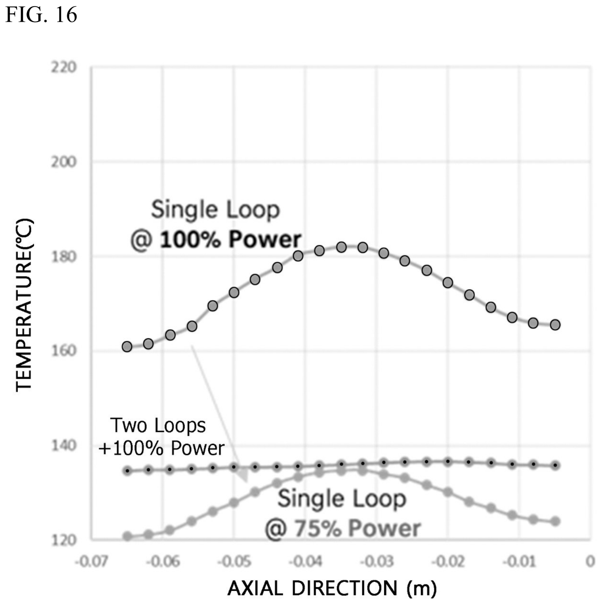

FIG. 16 is a graph showing an example of the output of the propulsion unit 100 when cooling is performed through the cooling channel CH according to the second example in a case where some of the first cooling unit 160A and the second cooling unit 160B fail and cooling is performed through one cooling unit 160.

Referring to FIG. 16, in the case where some of the first cooling unit 160A and the second cooling unit 160B fail and cooling is performed through one cooling unit 160, it can be seen that when cooling is performed through the cooling channel CH according to the second example, the output of the propulsion unit 100 can be up to 75% to match the temperature when the cooling units 160A and 160B are all normal (e.g., two loops for cooling circulate coolants). There is an advantage in that the output of the propulsion unit 100 can be increased more than when cooling is performed through the cooling channel CH according to the first example.

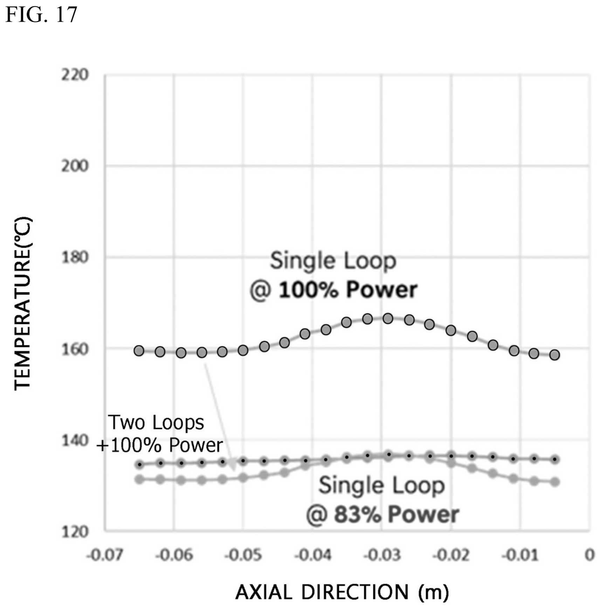

FIG. 17 is a graph showing an example of the output of the propulsion unit 100 when cooling is performed through the cooling channel CH according to the third example in a case where some of the first cooling unit 160A and the second cooling unit 160B fail and cooling is performed through one cooling unit 160.

Referring to FIG. 17, in the case where some of the first cooling unit 160A and the second cooling unit 160B fail and cooling is performed through one cooling unit 160, it can be seen that when cooling is performed through the cooling channel CH according to the third example, the output of the propulsion unit 100 can be up to 83% to match the temperature when the cooling units 160A and 160B are all normal (e.g., two loops for cooling circulate coolants). There is an advantage in that the output of the propulsion unit 100 can be increased more than when cooling is performed through the cooling channel CH according to the first and second examples.

In some implementations, by providing a plurality of cooling channels that independently operate, a propulsion unit can perform cooling even when some of the cooling channels are defective, thereby ensuring stable flight of a mobility apparatus.

In some implementations, since cooling channels are positioned between a stator and an inverter based on a radial direction perpendicular to an axial direction so that the cooling channels are adjacent to both the stator and the inverter, there is an advantage of high heat dissipation effect.

In some implementations, since cooling channels are positioned between a stator and an inverter based on a radial direction perpendicular to an axial direction, there is an advantage in that a distance between the stator and the inverter can be reduced and the overall size and weight of the propulsion unit can be reduced.

Although some example implementations of the present disclosure have been described above, it is understood that those skilled in the art can make various changes and modifications to the present disclosure without departing from the spirit and scope of the present disclosure set forth in the claims below.

## Claims

1. A propulsion unit comprising:
a stator;
a rotor configured to rotate relative to the stator;
an inverter electrically connected to the stator;
a cooling housing that is disposed adjacent to the stator and the inverter and defines a cooling channel, the cooling channel comprising a plurality of channels configured to carry coolant independently and circulate the coolant around the stator and the inverter; and
a cooling unit connected to the cooling channel, the cooling unit comprising at least one of a heat exchanger or a pump.

2. The propulsion unit of claim 1, wherein the cooling channel is disposed between the stator and the inverter.

3. The propulsion unit of claim 1, wherein the plurality of channels comprise a first channel and a second channel that are disposed adjacent to each other,
wherein the cooling unit comprises (i) a first cooling unit connected to the first channel and (ii) a second cooling unit connected to the second channel, and
wherein the first cooling unit and the second cooling unit are configured to independently operate.

4. The propulsion unit of claim 2, wherein each of the plurality of channels has an annular shape surrounding the stator.

5. The propulsion unit of claim 4, wherein outer surfaces of the plurality of channels face the stator in a radial direction of the stator, and inner surfaces of the plurality of channels face the inverter in the radial direction.

6. The propulsion unit of claim 3, wherein the first channel and the second channel are separately arranged in an axial direction of the rotor and spaced apart from each other in the axial direction.

7. The propulsion unit of claim 3, wherein the first channel and the second channel are alternately arranged in an axial direction of the rotor.

8. The propulsion unit of claim 7, wherein a first portion and a second portion of the first channel define a separation space therebetween in the axial direction of the rotor, and
wherein the second channel is disposed in the separation space between the first and second portions of the first channel.

9. The propulsion unit of claim 7, wherein a first portion and a second portion of the first channel define a first separation space therebetween in the axial direction of the rotor,
wherein a first part and a second part of the second channel defines a second separation space therebetween in the axial direction of the rotor,
wherein the first portion of the first channel is disposed in the second separation space, and
wherein the first part of the second channel is disposed in the first separation space.

10. The propulsion unit of claim 9, wherein the first channel comprises a first connecting portion that connects the first portion of the first channel and the second portion of the first channel, and
wherein the second channel comprises a second connecting portion that connects the first part of the second channel and the second part of the second channel.

11. The propulsion unit of claim 10, wherein the first connecting portion overlaps with the second channel in the axial direction of the rotor.

12. The propulsion unit of claim 10, wherein the second connecting portion overlaps with the first channel in the axial direction of the rotor.

13. The propulsion unit of claim 10, wherein the first channel, the second channel, the first connecting portion, and the second connection portion are disposed along a common circumferential surface.

14. The propulsion unit of claim 13, wherein the first connecting portion and the second connection portion extend parallel to the axial direction of the rotor.

15. The propulsion unit of claim 13, wherein each of the first channel and the second channel comprises at least a portion that is radially recessed outward relative to the common circumferential surface.
